# EUROPÄISCHE PATENTANMELDUNG

(11) **EP 0 910 127 A2**
(43) Veröffentlichungstag der Anmeldung: **21.04.1999**
(21) Anmeldenummer: 98116704.2
(22) Anmeldetag: 03.09.1998
(51) Int. Cl.: H01L 41/09

(54) **Piezoelektrischer Aktuator**

(30) Priorität: 15.10.1997 DE 19745468
(71) Anmelder: DaimlerChrysler AG, 70567 Stuttgart (DE)
(72) Erfinder: Jänker, Peter Dr., 85748 Garching (DE)

(57) **Zusammenfassung**

Bei einem piezoelektrischen Aktuator mit mindestens einer bei Anlegen einer elektrischen Spannung längenveränderlichen Festkörperstruktur (2), bestehend aus aufeinanderfolgend quer zur Längsrichtung der Festkörperstruktur verlaufenden, mittels Elektroden (4) wechselweise mit entgegengesetzter Polarität spannungsbeaufschlagbaren Piezoschichten (6) wird der Fertigungsaufwand erfindungsgemäß dadurch wesentlich vereinfacht, daß die Festkörperstruktur aus einer einstückigen, die Piezoschichten integral miteinander verbindenden piezokeramischen Platte besteht und diese auf der Außenfläche mit in Plattenlängsrichtung entsprechend der Schichtdicke der Piezoschichten (6) voneinander beabstandeten, jeweils in Plattenumfangsrichtung ringförmig geschlossenen Streifenelektroden (4) versehen ist.

## Beschreibung

Die Erfindung bezieht sich auf einen piezoelektrischen Aktuator nach dem Oberbegriff des Patentanspruchs 1.

Aus der US 25 40 194 und der US 52 25 731 sind Aktuatoren dieser Art mit einer einstückigen, piezoelektrischen Festkörperstruktur bekannt, die auf entgegengesetzten Außenflächen mit in Längsrichtung der Festkörperstruktur voneinander beabstandeten Streifenelektroden belegt ist, wobei einander gegenüberliegende Streifenelektroden elektrisch miteinander verbunden und in Längsrichtung benachbarte wechselweise mit entgegengesetzter Polarität spannungsbeaufschlagt sind, so daß eine Vielzahl von virtuellen, sich hinsichtlich der elektrisch induzierten Längenänderungen aufsummierenden Piezoschichten mit einer dem Elektrodenabstand entsprechenden Schichtdicke entsteht. Bei einem derartigen Aktuator besitzt die Festkörperstruktur zwar einen einfachen, weil monolithischen Aufbau, muß jedoch im Hinblick auf einen ausreichend homogenen Feldlinienverlauf mit einer geringen Plattenstärke ausgebildet werden und ist dementsprechend bruchgefährdet. Hinzukommt daß am Ende jeder Piezoschicht ein Elektroden-Doppelanschluß benötigt wird, so daß der Kontaktierungsaufwand bei einer größeren Anzahl von Piezoschichten erheblich ist.

Aufgabe der Erfindung ist es, einen piezoelektrischen Aktuator der eingangs genannten Art so auszubilden, daß die Herstellungsweise vereinfacht und die mechanische Stabilität und energetische Effizienz verbessert werden.

Diese Aufgabe wird erfindungsgemäß durch den im Patentanspruch 1 gekennzeichneten Aktuator gelöst.

Erfindungsgemaß wird aufgrund der um sämtliche querschnittsbegrenzenden Randflächen der Festkörperstruktur jeweils rundum geschlossenen Ausbildung der Streifenelektroden zum einen das elektrische Feldbild in den einzelnen Piezoschichten und dadurch die energetische Effizienz des Aktuators verbessert und zum anderen in Verbindung mit der die Streifenelektroden über interdigital ineinandergreifende Anschlußelektroden flächig kontaktierenden Trägerplatte sowohl die mechanische Festigkeit des Aktuators erhöht als auch auf fertigungsmäßig einfache Weise ein sichere und problemlose elekrische Verbindung zu den einzelnen Streifenelektroden hergestellt.

Um das Leistungsvermögen des Aktuators auf schaltungsmäßig einfache Weise zu erhöhen, empfiehlt es sich nach Anspruch 2, auf der Trägerplatte mehrere, nebeneinanderliegend unter gegenseitiger Kontaktierung ihrer Streifenelektroden miteinander verbundene Festkörperstrukturen zu befestigen.

Zur Bildung eines trimorphen, für Stellaufgaben quer zur Flächenerstreckung der Festkörperstruktur beidseitig biegeverformbaren Aktuators ist die Trägerplatte nach Anspruch 3 zweckmäßigerweise sowohl auf der Ober- als auch auf der Unterseite mit kammartig interdigital ineinandergreifenden Anschlußelektroden und über diese kontaktierten Festkörperstrukturen versehen.

Eine herstellungsmäßig besonders einfache Verbindung der Festkörperstruktruren untereinander und mit der Tägerplatte wird vorzugsweise nach Anspruch 4 durch gegenseitige Verklebung erzielt, wobei eine einwandfreie Kontaktierung der Streifenelektroden mit geringem Fertigungsaufwand dadurch garantiert wird, daß dem Kleber, wie nach Anspruch 5 bevorzugt, elektrisch leitende Kontaktierungspartikel in einer der Klebschichtdicke entsprechenden Korngröße beigemischt sind.

Aus Gründen einer weiteren fertigungsmäßigen Vereinfachung sind die Streifenelektroden nach Anspruch 6 vorzugsweise auf das piezoelektrische Festkörpermaterial aufgesputtert.

Die Erfindung wird nunmehr anhand mehrerer Ausführungsbeispiele in Verbindung mit den Zeichnungen näher erläutert. Es zeigen in stark schematisierter Darstellung:
- **Fig.1**: eine perspektivische Ansicht eines Aktuators mit einer einstückigen, plattenförmigen Festkörperstruktur und einer zugehörigen Träger- bzw. Leiterplatte vor ihrer gegenseitigen Verklebung;
- **Fig. 2**: die Ansicht eines piezoelektrischen Akrtüators mit zwei übereinanderliegenden, plattenförmigen Festkörperstrukturen nach Fig. 1; und
- **Fig. 3**: eine ausschnittsweise, der Deutlichkeit halber teilweise stark übertrieben vergrößerte Darstellung eines trimorphen Aktuators mit zwei beidseitig an eine Träger- bzw. Leiterplatte angeklebten Festkörperstrukturen.

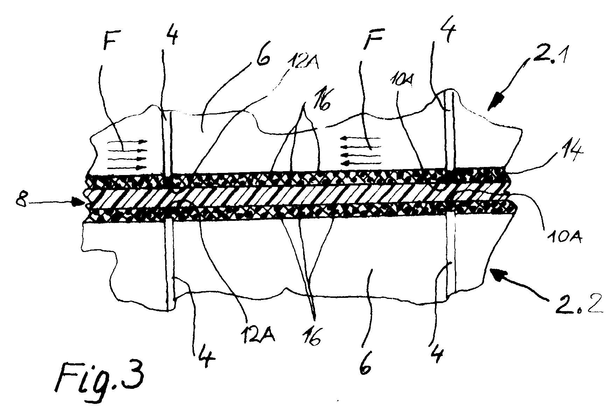

Der in den Fig. gezeigte piezoelektrische Aktuator enthält eine plattenförmige Festkörperstruktur 2, die einstückig aus einem piezokeramischen Material besteht und auf der Außenfläche in in Plattenlängsrichtung L gleichförmigen Abständen mit in Umfangsrichtung ringförmig geschlossenen, zu-einander parallelen Streifenelektroden 4 belegt ist. Wird an aufeinanderfolgende Streifenelektroden 4 ein abwechselnd niedriges und hohes Spannungspotential angelegt, so wird die Differenzspannung zwischen jeweils benachbarten Streifenelektroden 4 in der dazwischenliegenden Piezoschicht 6 der Festkörperstruktur 2 abgebaut und es werden in Längsrichtung L der Festkörperstruktur 2 antipolar gerichtete elektrische Felder F (Fig. 3) ausgeformt, unter deren Wirkung sich die Festkörperstruktur aufgrund des sich kumulierenden piezoelektrischen d33-Effekts der einzelnen Piezoschichten 6 in Plattenlängsrichtung ausdehnt.

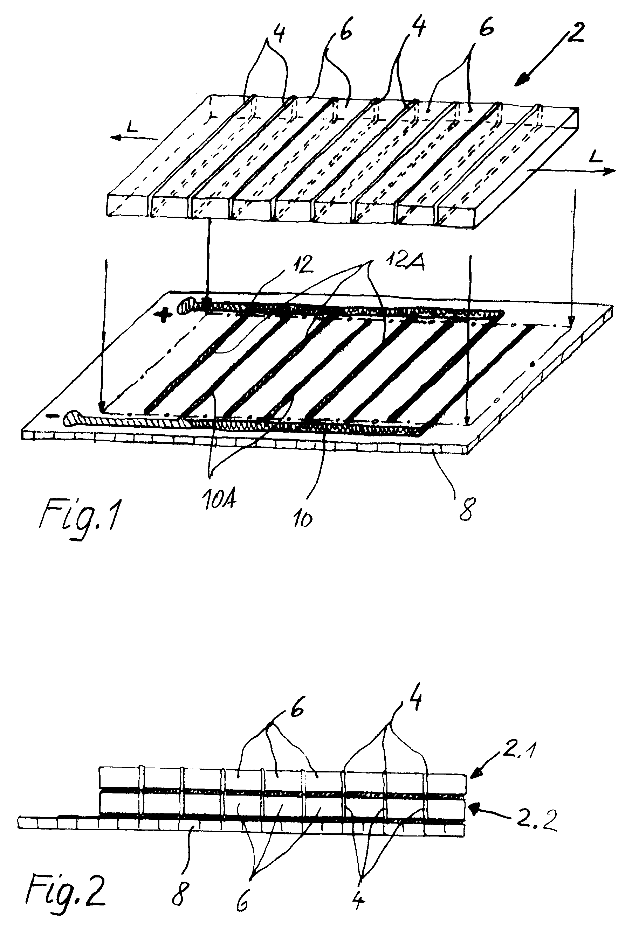

Zur elektrischen Versorgung der Streifenelektroden 4 ist eine Leiterplatte 8 vorgesehen, die mit kammförmig gestalteten, interdigital ineinandergreifenden Anschlußelektroden 10, 12 (Fig. 1) beschichtet ist, wobei die fingerartigen Leiterbahnen 10A und 12A gleichweit voneinander beabstandet sind wie die Streifenelektroden 4 der Festkörperstruktur 2.

Beim Zusammenbau des Aktuators wird die Leiterplatte 8 unter hohem Anpreßdruck vollflächig über eine dünne Klebstoffschicht 14 (Fig. 3) mit der Festkörperstruktur 2 verbunden und dabei exakt mit lagegenauer Ausrichtung der Elektroden 4 und 10A bzw. 12A bezüglich der Festkörperstruktur 2 positioniert. Dem Kleber, der aus einem elektrisch isolierenden Material besteht, sind elektrisch leitende Kontaktierungspartikel 16, z.B. Ni-Partikel, in einer der Dicke der Klebstoffschicht 14 entsprechenden Korngröße beigemischt, wodurch eine einwandfreie Kontaktierung der Streifenelektroden 4 mit den zugeordneten Leiterbahnen 10A bzw. 12A sichergestellt wird, die isolierende Wirkung der Klebstoffschicht 14 in den übrigen Bereichen jedoch erhalten bleibt.

Bei dem Ausführungsbeispiel nach Fig. 1 ist die Leiterplatte 8 einseitig mit einer Festkörperstruktur 2 verklebt. Besteht die Leiterplatte 8 aus einem weichelastischen Material, so bewirkt der piezoelektrische Effekt eine rein lineare Längenänderung der Festkörperstruktur 2, wobei sich die Expansions- und Kontraktionsbewegungen der Festkörperstruktur 2 über die schubfeste Verklebung 14 auf die Leiterplatte 8 übertragen. Wird die Leiterplatte 8 hingegen in Längsrichtung L hochsteif ausgebildet, so kann sie den elektrisch induzierten Längenänderungen der Festkörperstruktur 2 nicht folgen und der Aktuator arbeitet nach Art eines bimorphen, sich quer zur Plattenebene verbiegenden Stellelements.

Der Aktuator nach Fig. 2 entspricht hinsichtlich seiner Bau- und Funktionsweise weitgehend dem ersten Ausführungsbeispiel enthält jedoch zur Leistungsverstärkung zwei übereinanderliegende Festkörperstrukturen 2.1 und 2.2, die unter gegenseitiger Kontaktierung ihrer Elektrodenringe 4 - wiederum mittels einer mit Kontaktierungspartikeln angereicherten Klebstoffschicht - kraftübertragend miteinander verbunden sind.

Fig. 3 zeigt einen trimorphen Aktuator mit zwei äußeren Festkörperstrukturen 2.1 und 2.2 und einer zwischen diese eingeklebten Leiterplatte 8, die beidseitig mit Anschlußelektroden 10 und 12 belegt ist. Durch die getrennte elektrische Ansteuerung der beiden Festkörperstrukturen ist es möglich, den Aktuator aus der gezeigten Nullage in beiden Richtungen quer zur Platten-ebene aktiv zu verbiegen.

Bei einem konkreten Ausführungsbeispiel wurde die Festkörperstruktur 2 aus einer einstückigen piezokeramischen Platte in einer Länge von 40 mm, einer Breite von 10 mm und einer Dicke von 200 µm mit in Umfangsrichtung geschlossenen, 20 µm breiten und etwa 5 µm hohen Streifenelektroden 4 hergestellt, wobei die Dicke der einzelnen Piezoschichten 6, also der gegenseitige Elektrodenabstand 250 µm betrug. Die Dicke der Klebstoffschicht 14 und die Korngröße der Ni-Partikel 16 lag bei 10 µm. Zur Herstellung der Streifenelektroden 4 wird die unpolarisierte, gesinterte Keramikplatte entweder auf der gesamten Außenfläche gleichmäßig dünn mit einem elektrisch leitfähigen Material, z.B. auf elektrochemischem Wege, beschichtet und anschließend werden die Streifenelektroden 4 durch mechanische Bearbeitung, durch Laserbearbeitung oder durch Ätzen herausgearbeitet, oder die Streifenelektroden 4 werden direkt auf die piezokeramische Platte aufgesputtert.

Unter Ausnutzung des direkten piezoelektrischen Effekts läßt sich die beschriebene Festkörperstruktur auch als Verformungssensor verwenden.

## Patentansprüche

1. Piezoelektrischer Aktuator mit mindestens einer bei Anlegen einer elektrischen Spannung längenveränderlichen Festkörperstruktur aus einem einstückigen Piezomaterial mit aufeinanderfolgend quer zur Längsrichtung der Festkörperstruktur verlaufenden, integral miteinander verbundenen Piezoschichten und entsprechend der Schichtdicke der Piezoschichten voneinander beabstandeten, in Umfangsrichtung der Festkörperstruktur verlaufenden, wechselweise mit entgegengesetzter Polarität spannungsbeaufschlagbaren Streifenelektroden,
**dadurch gekennzeichnet, daß**
die einzelnen Streifenelektroden (4) jeweils die querschnittsbegrenzenden Oberflächen der Festkörperstruktur (2) vollständig umgreifend ausgebildet sind und die Festkörperstruktur auf einer Trägerplatte (8) mit kammförmig ausgebildeten, interdigital ineinandergreifenden, die Streifenelektroden wechselweise kontaktierenden Anschlußelektroden (10, 12) befestigt ist.

2. Piezoelektrischer Aktuator nach Anspruch 1,
**dadurch gekennzeichnet, daß**
auf der Trägerplatte (8) mehrere, nebeneinanderliegend unter gegenseitiger Kontaktierung ihrer Streifenelektoden (4) miteinander verbundene Festkörperstrukturen (2.1, 2.2) befestigt sind.

3. Piezoelektrischer Aktuator nach Anspruch 1 oder 2,
**dadurch gekennzeichnet, daß**
die Trägerplatte (8) zur Bildung eines trimorphen Aktuators beidseitig mit über Anschlußelektroden (10, 12) kontaktierten Festkörperstrukturen (2.1, 2.2) versehen ist.

4. Piezoelektrischer Aktuator nach einem der vorhergehenden Ansprüche,
**dadurch gekennzeichnet, daß**
die Festkörperstrukturen (2) miteinander bzw. mit der Trägerplatte (8) verklebt sind.

5. Piezoelektrischer Aktuator nach Anspruch 4,
**dadurch gekennzeichnet, daß**
dem Kleber (14) elektrisch leitende Kontaktierungspartikel (16) in einer der Klebschichtdicke entsprechenden Korngröße beigemischt sind.

6. Piezoelektrischer Aktuator nach einem der vorhergehenden Ansprüche,
**dadurch gekennzeichnet, daß**
die Streifenelektroden (4) auf das piezoelektrische Festkörpermaterial aufgesputtert sind.
